# EUROPÄISCHE PATENTSCHRIFT

(11) **EP 1 239 293 B1**
(45) Veröffentlichungstag und Bekanntmachung des Hinweises auf die Patenterteilung: **23.11.2005**
(21) Anmeldenummer: 02100219.1
(22) Anmeldetag: 05.03.2002
(51) Int. Cl.: G01R 31/3181

(54) **Anordnung zum Testen von integrierten Schaltkreisen**
Device for testing integrated circuits
Dispositif de test de circuits intégrés

(30) Priorität: 07.03.2001 DE 10110777
(43) Veröffentlichungstag der Anmeldung: 11.09.2002
(73) Patentinhaber: Philips Intellectual Property & Standards GmbH, 20099 Hamburg (DE); Koninklijke Philips Electronics N.V., 5621 BA Eindhoven (NL)
(72) Erfinder: Hapke, Friedrich, Weisshausstrasse 2, 52066 Aachen (DE)
(74) Vertreter: Volmer, Georg

(56) Entgegenhaltungen:
- US-A- 3 887 869
- US-A- 6 041 429
- KIEFER G ET AL: "USING BIST CONTROL FOR PATTERN GENERATION" PROCEEDINGS OF THE INTERNATIONAL TEST CONFERENCE. ITC '97. WASHINGTON, DC, NOV. 1 - 6, 1997, INTERNATIONAL TEST CONFERENCE, NEW YORK, NY: IEEE, US, Bd. CONF. 28, 1. November 1997 (1997-11-01), Seiten 347-355, XP000800332 ISBN: 0-7803-4210-0

## Beschreibung

Die Erfindung betrifft eine Anordnung und ein Verfahren zum Testen von integrierten Schaltkreisen.

Integrierte Schaltkreise werden nach deren Herstellung getestet; dazu werden ihnen im Allgemeinen sogenannte Testvektoren zugeführt, bei denen es sich um Datenworte handelt, die den Eingängen des integrierten Schaltkreises zugeführt werden und die an den Ausgängen ein bestimmtes Verhalten des integrierten Schaltkreises produzieren, das mit einem Sollverhalten verglichen wird. Damit ist feststellbar, ob der integrierte Schaltkreis fehlerfrei arbeitet, also korrekt hergestellt wurde.

Durch die zunehmende Integrationsdichte derartiger integrierter Schaltkreise nimmt die Zahl der erforderlichen Testvektoren immer mehr zu. Nach dem Stand der Technik werden diese Testvektoren in Vektorspeichern gespeichert. Es handelt sich dabei um ggf. mehrere Millionen Testvektoren pro Pin des zu testenden integrierten Schaltkreises. Durch diese hohe Zahl wird der Aufwand für derartige Testsysteme sehr hoch, was wiederum zur Erhöhung der Herstellungskosten des zu testenden integrierten Schaltkreises führt.

Eine andere, nach dem Stand der Technik bekannte Lösung, ist ein sogenannter Built-In-Self-Test (BIST), bei dem auf dem integrierten Schaltkreis eine spezielle Testschaltung vorgesehen ist, welche mit einem externen, einfachen Testsystem zusammenarbeitet. Dies wiederum hat den Nachteil, daß auf dem integrierten Schaltkreis zusätzlicher Flächenbedarf für die Testschaltung entsteht, und daß außerdem die auf dem integrierten Schaltkreis vorhandene Nutzschaltung modifiziert werden muß. Dies wiederum birgt die Gefahr, daß diese Nutzschaltung nicht optimal aufgebaut werden kann.

Aus US-A-3 887 869 ist eine Anordnung bekannt, in welcher Testmuster erzeugt werden, die Eingängen eins zu testenden integrierten Schaltkreises zugeführt werden, dessen Ausgangssignale mit den Ausgangssignalen eines "idealen", fehlerfreien Testmusters verglichen werden.

In dem zu prüfenden integrierten Schaltkreis können ggf. Schaltungselemente vorgesehen sein, die ein undefiniertes oder Speicher-Verhalten aufweisen. In diesem Fall ist eine Auswertung der Ausgangsmuster des integrierten Schaltkreises beim Testen nicht möglich.

Es ist Aufgabe der Erfindung, eine Anordnung zum Testen von integrierten Schaltkreisen anzugeben, welche derartige undefineirte Ausgangsmuster beim Testen nicht berücksichtigt.

Diese Aufgabe wird erfindungsgemäß durch die Merkmale des Patentanspruchs 1 gelöst:

Anordnung zum Testen eines integrierten Schaltkreises mit einem Datenwort-Generator, der deterministische Datenworte liefert, mit Mitteln zur Testmuster-Generierung, die die deterministischen Datenworte so verändern, daß vorgegebene Testmuster, die Eingängen eines zu testenden, integrierten Schaltkreises zuführbar sind, entstehen und mit Vergleichsmitteln zum Vergleichen von Test-Ausgangsmustern des integrierten Schaltkreises mit Soll-Ausgangsmustern, wobei die Anordnung außerhalb des zu testenden, integrierten Schaltkreises vorgesehen ist, wobei eine Maskierungslogik (13; 29) vorgesehen ist, welche bewirkt, daß die Vergleichsmittel (12; 30) ausschließlich vorgegebene Test-Ausgangsmuster des zu testenden integrierten Schaltkreises (1; 21) mit den Soll-Ausgangsmustern vergleicht.

Bei der erfindungsgemäßen Anordnung zum Testen eines integrierten Schaltkreises kann auf einen umfangreichen Vektorspeicher verzichtet werden. Es ist stattdessen ein Daten wort-Generator vorgesehen, der deterministische Datenworte liefert. Dies heißt also, daß der Datenwort-Generator eine Folge von Datenworten liefert, die bekannt, also vorhersagbar sind.

Diese deterministischen Datenworte des Datenwort-Generators werden bitweise mittels Mitteln zur Testmuster-Generierung modifiziert. Dabei werden die einzelnen Bits eines jeden dieser deterministischen Datenworte so verändert, daß vorgegebene, deterministische Testmuster entstehen. Diese Testmuster sind dazu vorgesehen, den Eingängen des zu testenden, integrierten Schaltkreises zugeführt zu werden bzw. die Soll-Ausgangsmuster darstellen.

Es werden durch die Modifikation ebenfalls Soll-Ausgangsmuster erzeugt. Die Ausgangssignale des zu testenden, integrierten Schaltkreises, die durch die Testmuster entstehen, werden mittels Vergleichsmitteln mit diesen Soll-Ausgangsmustern verglichen.

Auf diese relativ einfache Weise kann eine Testmuster-Generation erfolgen, die keinen Testmusterspeicher erfordert, in dem alle Testmuster bzw. Testvektoren gespeichert sind. Vielmehr kann eine Folge aufeinanderfolgender Testmuster durch den Datenwort-Generator und die Mittel zur Testmuster-Generierung sequenziell erzeugt werden, ohne daß diese im einzelnen in einem Speicher vorhanden sein müssen.

Die Anordnung ist außerhalb eines integrierten Schaltkreises vorgesehen und erfordert auf dem integrierten Schaltkreis, der zu testen ist, keine besonderen Vorkehrungen, d.h. also insbesondere keine Modifikation der zu testenden Schaltung des Schaltkreises und auch keinen zusätzlichen Flächenbedarf auf dem integrierten Schaltkreis.

Die erfindungsgemäße Anordnung wird im Allgemeinen mit einem einfachen Testsystem zusammenarbeiten, das im Wesentlichen die Steuerung der Anordnung und ggf. die Auswertung der Vergleichsergebnisse vornimmt.

In dem integrierten Schaltkreis können ggf. Schaltungselemente vorgesehen sein, die ein undefiniertes oder Speicher-Verhalten aufweisen. In diesem Fall ist eine Auswertung der Ausgangsmuster des integrierten Schaltkreises beim Testen nicht möglich. Es handelt sich im Allgemeinen dabei um bestimmte Ausgangs-Testmuster in bestimmten Phasen des Testens, die nicht ausgewertet werden können bzw. sollten. Zur Lösung dieses Problems ist gemäß einer weiteren Ausgestaltung der Erfindung nach Anspruch 4 eine Maskierungslogik vorgesehen, welche die Vergleichsmittel in der Anordnung so steuert, daß nur vorgegebene Test-Ausgangsmuster des zu testenden, integrierten Schaltkreises mit den Soll-Mustern verglichen werden. Mit anderen Worten: Maskiert diese Logik bestimmte Ausgangsmuster, d.h. Ausgangsmuster, die aus den oben erläuterten Gründen nicht ausgewertet werden sollen, werden bzgl. der Auswertung unterdrückt.

Die Mittel zur Testmuster-Generierung gliedern sich gemäß einer weiteren Ausgestaltung der Erfindung gemäß Anspruch 2 vorteilhaft in eine Bit-Flipping-Steuerung und in Bit-Flipping-Logiken, die durch die Bit-Flipping-Steuerung angesteuert werden. Die Bit-Flipping-Logiken sind dazu vorgesehen, einzeln die Bits eines jeden von dem Datenwort-Generator gelieferten deterministischen Datenwortes so zu modifizieren, daß für das jeweilige Bit ausgangsseitig der gewünschte Wert erreicht wird, so daß die Bit-Flipping-Logiken insgesamt ausgangsseitig ein gewünschtes vorgegebenes, deterministisches Testmuster-Datenwort liefern, das den Eingängen des zu testenden, integrierten Schaltkreises zugeführt wird.

Nachfolgend wird ein Ausführungsbeispiel der Erfindung anhand der Zeichnung näher erläutert. Es zeigen:
- Figur 1: ein Blockschaltbild der erfindungsgemäßen Anordnung und
- Figur 2: ein detaillierteres Blockschaltbild der erfindungsgemäßen Anordnung auf einem Testboard, das zwischen ein zu testendes IC und ein Testsystem geschaltet ist.

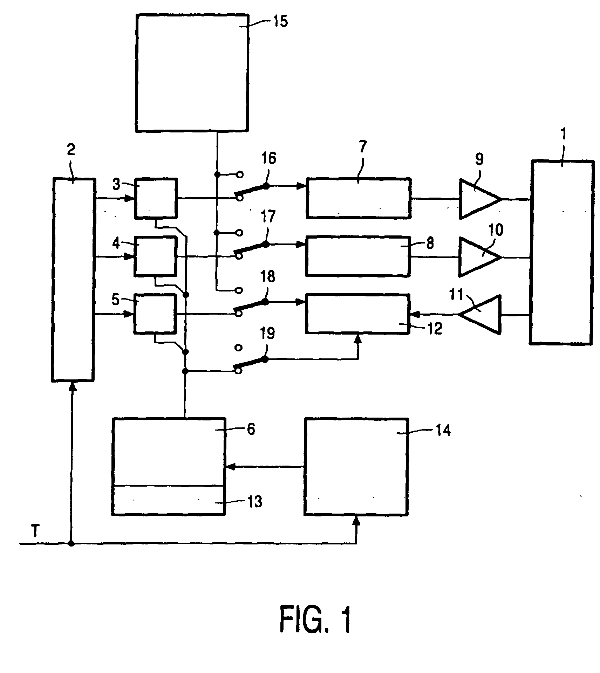

Figur 1 zeigt ein Blockschaltbild der erfindungsgemäßen Anordnung zum Testen eines integrierten Schaltkreises 1.

Die Anordnung weist einen Datenwort-Generator 2 auf, der als rückgekoppeltes Schieberegister aufgebaut ist. Der Datenwort-Generator 2 wird durch ein Taktsignal T angesteuert, mittels welchem der Testvorgang gesteuert wird. Mit jeder neuen Flanke des Taktsignals T liefert der Datenwort-Generator ein neues deterministisches Datenwort. Deterministisch bedeutet in diesem Zusammenhang, däß es sich um eine bekannte Folge von Datenworten handelt, so daß also für jeden Takt des Taktsignals T bekannt ist, wie das jeweils von dem Datenwort-Generator 2 gelieferte Datenwort aussieht.

Die so erzeugten Datenworte des Datenwort-Generators 2 sind selber als Testvektoren noch nicht geeignet, da die Testvektoren bestimmte Bit-Werte aufweisen sollen, die von denen der Datenworte abweichen.

Es sind daher Mittel zur Testmuster-Generierung vorgesehen, die aus den von dem Datenwort-Generator 2 gelieferten deterministischen Datenworte vorgegebene, deterministische Testmuster und Soll-Ausgangsmuster erzeugen.

Die Mittel zur Testmuster-Generierung weisen sogenannte Bit-Flipping-Logiken 3, 4 und 5 auf, denen eingangsseitig die jeweiligen Bits eines Datenwortes zugeführt werden. In dem Ausführungsbeispiel gemäß Figur 1 bestehen übersichtshalber die als Testmuster vorgesehenen Datenworte nur aus jeweils 2 Bits und die als Soll-Ausgangsmuster vorgesehenen Datenworte aus jeweils einem Bit.

Die Bit-Flipping-Logiken 3, 4 und 5 werden mittels einer Bit-Flipping-Steuerung 6, welche ebenfalls zu den Mitteln zur Testmuster-Generierung gehört, angesteuert. Die Bit-Flipping-Steuerung 6 steuert dabei für jedes neue Datenwort, das von dem Datenwort-Generator 2 in Abhängigkeit des Taktsignals T geliefert wird, deren Bits einzeln so verändert werden, dass am Abgang der Bit-Flipping-Logiken 3, 4 und 5 die gewünschten Bits der jeweiligen Datenworte und Soll-Ausgangsmuster entstehen, die somit deterministisch sind.

Dabei sollen die Bit-Flipping-Logiken 3, 4 und 5 ein Datenwort liefern, das den Eingängen des zu testenden IC's zugeführt wird. Ferner liefern sie für jeden Testschritt ein Datenwort als Soll-Ausgangsmuster, das mit dem Ausgangssignal des zu testenden IC's 1 verglichen wird.

In dem Ausführungsbeispiel gemäß Figur 1 besteht der Einfachheit halber dasjenige Datenwort, das auf die Eingänge des zu testenden IC's 1 gekoppelt wird, nur aus 2 Bits Das Ebenfalls von den Mitteln zur Testmuster-Generierung zu erzeugende Soll-Ausgangstestmuster besteht der Einfachheit halber nur aus einem Bit.

Diebeiden Bit-Flipping-Logiken 3 und 4 erzeugen in dem Ausführungbeispiel gemäß Figur 1 die beiden Bits eines jeden Datenwortes, das auf die Eingänge des zu testenden IC 1 gekoppelt wird. Hingegen erzeugt die Bit-Flipping-Logik 5 das einzige Bit eines jeden Soll-Ausgangsmusters.

Die von den beiden Bit-Flipping-Logiken 3 und 4 gelieferten Datenworte werden über Signalformer 7 und 8 und Treiberstufen 9 und 10 auf Eingänge des zu testenden, integrierten Schaltkreises 1 gekoppelt.

Mit jedem Testschritt und somit jedem neuen Datenwort, das mittels der Treiber 9 und 10 auf die Eingänge des zu testenden, integrierten Schaltkreises 1 gekoppelt wird, liefert der integrierte Schaltkreis 1 ausgangsseitig ein Ausgangsmuster, das über eine Treibestufe 11 an einen Komparator 12 gelangt. Der Komparator 12 ist Bestandteil von Vergleichsmitteln, welche zum Vergleichen der Testausgangsmuster des zu testenden, integrierten Schaltkreises mit Soll-Ausgangsmustern dient.

In dem Ausführungsbeispiel gemäß Figur 1 werden, wie oben bereits erläutert, die Soll-Ausgangsmuster durch die Bit-Flipping-Logik 5 erzeugt. In diesem Ausführungsbeipiel handelt es sich nur um 1 Bit für jedes Soll-Ausgangsmuster.

Der Komparator 12 vergleicht also für jeden Testschritt das Test-Ausgangmuster des zu testenden, integrierten Schaltkreises 1 mit dem jeweiligen Soll-Ausgangsmuster, das von der Bit-Flipping-Logik 5 stammt. Somit kann für jeden Testschitt und für jedes neue, dem integrierten Schaltkreis 1 zugeführte Testmuster bzw. Test-Datenwort das Ausgangsverhalten des integrierten Schaltkreises überprüft werden.

Die Auswertung der von dem Komparator 12 gelieferten Ergebnisse wird in der Figur nicht näher dargestellter Weise beipielsweise mittels eines einfachen Testsystems vorgenommen.

Ggf. kann der integrierte Schaltkreis 1 bzw. einzelne Elemente dieses Schaltkreises ein undefiniertes Verhalten aufweisen, das dazu führt, dass nicht alle Ausgangssignale des integrierten Schaltkreises 1 auszuwerten sind. Insbesondere kann in einzelnen Testschritten ein Unterdrücken der Ausgangssignale sinnvoll sein.

Dazu ist zusätzlich eine Maskierungslogik 13 vorgesehen, welche den Komparator 12 so ansteuert, dass in bestimmten Testphasen ein Vergleich nicht stattfindet bzw. das Vergleichsergebnis nicht zur Auswertung weitergegeben wird.

Wie oben bereits erläutert, wird der Ablauf des Testens des integrieten Schaltkreises 1 durch das Taktsignal T gesteuert. Mit jedem Takt dieses Taktsignals T liefert der Datenwort-Generator 2 ein neues deterministisches Datenwort an die Bit-Flipping-Logiken 3,4 und 5. Es handelt sich zwar um deterministische Datenworte, jedoch muß jederzeit bekannt sein, um welches Datenwort es sich handelt, damit dessen Wert bekannt ist. Um dieses sicherzustellen, ist ein Testvektor-Zähler 14 vorgesehen, der das Taktsignal T zählt und das Zählergebnis an die Bit-Flipping-Steuerung 6 und die Maskierungslogik 13 liefert. Somit ist diesen jederzeit bekannt, in welcher Testphase sich der Testvorgang befindet. Die Bit-Flipping-Steuerung 6 kann somit für jeden neuen Takt des Taktsignals T aufgrund der Tatsache, dass das von dem Datenwort-Generator 2 gelieferte Datenwort bekannt ist, die Bit-Flipping-Logiken 3, 4 und 5 so ansteuern, dass die ausgangsseitig die gewünschten deterministischen Datenworte bzw. Soll-Ausgangsmuster liefern.

Durch diese erfindungsgemäße Anordnung kann der integrierte Schaltkreis 1 getestet werden, ohne dass auf dem Schaltkreis dazu besondere Schaltungselemente oder gar On-Board-Testsysteme erforderlich sind.

Auch kann durch die erfindungsgemäße Anordnung grundsätzlich ein Testvektoren-Speicher eingespart werden, in dem sonst nach dem Stand der Technik alle Bits eines jeden Testvektors bzw. Test-Datenwortes einzeln abgespeichert sind.

Zur Flexibilisierung, beispielsweise um neue, nicht vorgesehene Testvektoren beim Test einzusetzen, kann zusätzlich ein Testvektorspeicher 15 vorgesehen sein, der mittels elektronischer Schalter 16, 17, 18 und 19 anstelle der Ausgänge der Bit-Flipping-Logiken 3, 4 und 5 auf die Signalformer 7 und 8 bzw. den Komparator 12 geschaltet werden können. Auch wird durch in dem Testvektorspeicher 15 abgespeicherte Daten für jeden Testschritt festgelegt, ob der Komparator 12 einen Vergleich eines Soll-Ausgangsmusters mit dem tatsächlich von dem integrierten Schaltkreis 1 gelieferten Ausgangs-Testmuster vornehmen soll. Dazu ist der elektronische Schalter 19 vorgesehen, mittels dessen die Ansteuerung des Komparators 12 entweder auf den Testvektorspeicher 15 oder auf die Bit-Flipping-Steuerung 6 geschaltet werden kann.

Es ist jedoch ausdrücklich festzustellen, dass der Testvektorspeicher 15 lediglich optional vorgesehen ist und für die Funktion der erfindungsgemäßen Anordnung nicht erforderlich ist.

Deren Funktionsweise besteht vielmehr darin, von dem Datenwort-Generator 2 gelieferte deterministische Datenworte mittels der Bit-Flipping-Steuerung 6 und der Bit-Flipping-Logiken 3 und 4 so zu gestalten, dass dem zu testenden, integrierten Schaltkreis 1 Testmuster vorgegebener deterministischer Werte zugeführt werden. Die von dem zu testenden, integrierten Schaltkreis 1 ausgangsseitig gelieferten Ausgangs-Testmuster werden mit Soll-Testmustern verglichen, die mit Soll-Ausgangsmustern verglichen werden, die von der Bit-Flipping-Logik 5 geliefert werden. Auch diese Soll-Ausgangsmuster werden mittels der Bit-Flipping-Logik 5 und der Bit-Flipping-Steuerung 6 aus deterministischen Datenworten des Datenwort-Generators 2 gewonnen.

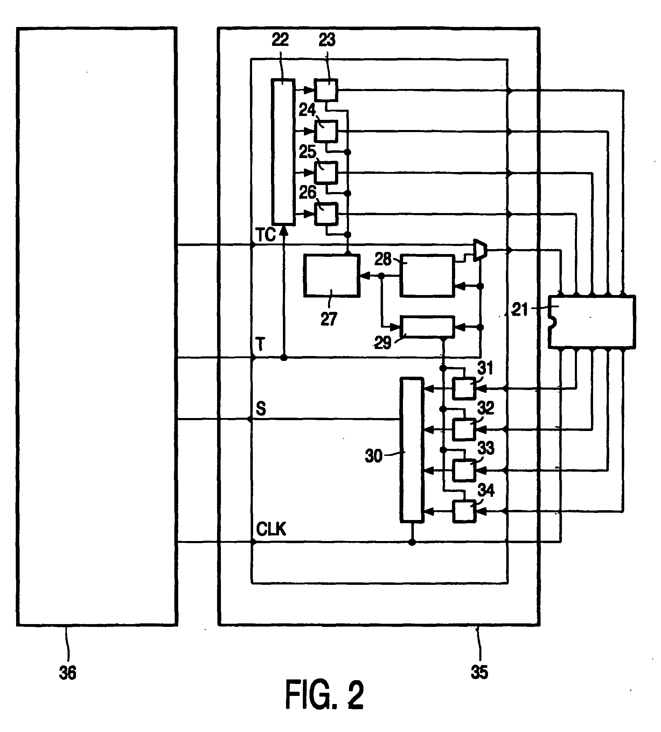

In Figur 2 ist eine erfindunsgemäße Anordnung zum Testen eines integrierten Schaltkreises 1 dargestellt, welche gegenüber derjenigen gemäß Figur 1 geringfügig modifiziert ist. Insbesondere die Vergleichsmittel sind in dem Ausführungsbeispiel gemäß Figur 2 anders aufgebaut.

Die Figur 2 zeigt die erfindungsgemäße Anordnung zum Testen des integrierten Schaltkreises 21 auf einem Testboard 35, welches zwischen den zu testenden, integrierten Schaltkreis 21 und ein einfaches Testsystem 36 geschaltet ist. Das Testsystem 36 dient dabei vor allem zur Erzeugung bestimmter Taktsignale, auf die noch einzugehen sein wird, und zur Auswertung der Vergleichsergebnisse.

Die auf dem Testboard 35 aufgebaute erfindungsgemäße Anordnung kann insbesondere als programmierbare Logik realisiert sein.

Die erfindungsgemäße Anordnung gemäß Figur 2 weist einen Testvektoren-Generator 22 auf, dem Bit-Flipping-Logiken 23, 24, 25 und 26 nachgeschaltet sind. In diesem Fall dienen die Bit-Flipping-Logiken 23 bis 26 dazu, mit jedem Taktschritt ein 4-Bit-breites Testmuster zu generienen, das 4 Eingängen des zu testenden, integrierten Schaltkreises 21 zugeführt wird.

Wie bereits anläßlich des Ausführungsbeispiels gemäß Figur 1 erläutert, werden auch in diesem Ausführungsbeispiel gemäß Figur 2 die Bit-Flipping-Logiken 23 bis 26 mittels einer Bit-Flipping-Steuerung 27 angesteuert.

Auch in dem Ausführungbeispiel gemäß Figur 2 ist ein Testvektor-Zähler 28 vorgesehen, der die Bit-Flipping-Steuerung 27 ansteuert. Ferner ist eine Maskierungs-logik 29 vorgesehen, die ebenfalls von dem Testvektor-Zähler 28 angesteuert wird.

Ein Test-Steuereingang des zu testenden integrierten Schaltkreiss 1 wird durch ein Steuersignal angesteuert, das sich durch und Verknüpfung mittels eine UND-Gatters aus einem von dem Testsystem 36 gelieferten Signal TC und einem von dem Testvektoren-Zähler 28 gelieferten Signal ergibt. Auf diese Weise wird der zu testende integrierte Schaltkreis 21 so gesteuert, dass er jeweils neue Testmuster zu gewünschten Zeitpunkten übernimmt.

In dem Ausführungsbeispiel gemäß Figur 2 werden die Soll-Ausgangsmuster nicht mittels eines Datenwort-Generators und Bit-Flipping-Logiken erzeugt, sondern es wird mittels eines Signatur-Registers 30 eine Komprimierung aller in einem Testvorgang schrittweise ausgelesenen Ausgangs-Testmuster des zu testenden, integrierten Schaltkreises 21 miteinander verknüpft und schließlich durch das Testsystem 36 ausgewertet, wobei ein Vergleich mit einem Soll-Ausgangsmuster vorgenommen wird Dabei wird in jedem Testschritt für jedes neue Datenwort eine Exklusiv-Oder-Verknüpfung mit dem bereits in dem Signatur-Register 30 zwischengespeicherten Datenwort vorgenommen. Dieser Vorgang wiederholt sich für jeden neuen Testmuster-Schritt. Am Ende eines Testvorgangs wird das Signatur-ergebnis an dasTestsystem36 geliefert, welches dieses Ergebnis auswertet. Das Signaturregister 30 wird ausgangsseitig ebenso wie der zu testende, integrierte Schaltkreis 21 mittels eines Taktsignals CLK getaktet.

Bei dieser Vorgehensweise kann es, ebenso wie in dem Ausführungsbeispiel gemäß Figur 1 vorkommen, dass aufgrund undefinierten Verhaltens von Bauelementen in den zu testenden, integrierten Schaltkreis 21 bestimmte Ausgänge des integrierten Schaltkreises in bestimmten Testphasen Signale liefern, die nicht auswertbar sind, da sie zufällige Werte annehmen.

In dem Ausführungsbeispiel gemäß Figur 2 sind deshalb Bit-Modifikations-Logiken 31, 32, 33 und 34 vorgesehen, mit denen solche Bits, die normalerweise nicht ausgewertet werden können, auf bestimmte Sollwerte modifiziert werden. Dies ist erforderlich, damit an den Eingängen des Signaturregisters 30 definierte Zustände für jeden Testschritt vorliegen, da nur so eine Verknüpfung aller Testmuster, die dem Signaturregister 30 zugeführt werden, über alle Testschritte möglich ist bzw. definierte Ergebnisse liefert.

Zusammenfassend ist festzustellen, dass in dem Ausführungsbeispeil gemäß Figur 1 der Datenwort-Generator und die Mittel zur Testmuster-Generierung, also insbesondere die Bit-Flipping-Logiken und die Bit-Flipping-Steuerung dazu dienen, sowohl Testmuster zu generieren, die eingangsseitig dem zu testenden integrierten Schaltkreis zugeführt werden, als auch Soll-Ausgangsmuster, die mit tatsächlichen Ausgangsmustem des integrierten Schaltkreises beim Testen verglichen werden.

Im Unterschied hierzu werden in dem Ausführungsbeispiel gemäß Figur 2 der Datenwort-Generator 22 und die Mittel zum Erzeugen von Testmustern ausschließlich dazu eingesetzt, Eingangs-Testmuster für das zu testende Objekt zu erzeugen. Die Ausgangs-Testmuster werden in dem zweiten Ausführungsbeispiel gemäß Figur 2 über ein Signatur-Register miteinander verknüpft, so dass das Signatur-Register am Ende eines Testvorgangs ein Signatur-Ergebnis liefert, das nur noch ein Datenwort darstellt und das mit einem Soll-Datenwort, das beispielweise in dem Testsystem fest abgespeichert ist, verglichen wird.

Für beide Ausführungsbeispiele der Erfindung gilt, dass ein Testen mit einer Vielzahl von Testvektoren möglich ist, ohne umfangreiche Testvektor-Speicher vorzusehen. Auch müssen in beiden Fällen die zu testenden, integrieten Schaltkreise keine On-Board-Testsysteme beinhalten. Ferner ist eine Modifikation der zu testenden Schaltungen auf dem integrierten Schaltkreis nicht erforderlich.

## Patentansprüche

1. Anordnung, zum Testen eines integrierten Schaltkreises (1; 21), mit einem Datenwort-Generator (2; 22), der deterministische Datenworte liefert, mit Mitteln (3,4,5,6; 22, 23, 24, 25, 26,27) zur Testmuster- Generierung, die die deterministischen Datenworte so verändern, daß vorgegebene, deterministische Testmuster, die Eingängen eines zu testenden integrierten Schaltkreises (1; 21) zuführbar sind, entstehen, und mit Vergleichsmitteln (12; 30) zum Vergleichen von Test-Ausgangsmustern des integrierten Schaltkreises (1; 21) mit wenigstens einem Soll-Ausgangsmuster, wobei die Anordnung außerhalb des zu testenden integrierten Schaltkreises (1; 21) vorgesehen ist, wobei eine Maskierungslogik (13; 29) vorgesehen ist, welche bewirkt, daß die Vergleichsmittel (12; 30) ausschließlich vorgegebene Test-Ausgangsmuster des zu testenden integrierten Schaltkreises (1; 21) mit den Soll-Ausgangsmustern vergleicht.

2. Anordnung nach Anspruch 1,
**dadurch gekennzeichnet,**
**daß** als Mittel (3,4,5,6; 22,23,24,25,26,27) zur Testmuster-Generierung eine Bit-Flipping-Steuerung (6; 27) vorgesehen ist, die Bit-Flipping-Logiken (3,4,5; 23,24,25,26) so steuert, daß die deterministischen Datenworte bitweise so verändert werden, daß die vorgegebenen, deterministischen Testmuster entstehen.

3. Anordnung nach Anspruch 1,
**dadurch gekennzeichnet,**
**daß** die Soll-Ausgangsmuster mittels des Datenwort-Generators (2) und der mit Mittel (3,4,5,6) zur Testmuster-Generierung erzeugt werden.

## Claims

1. An arrangement for testing an integrated circuit (1; 21), having a data word generator (2; 22), which supplies deterministic data words, having means (3, 4, 5, 6; 22, 23, 24, 25, 26, 27) for test pattern generation, which modify the deterministic data words such that predetermined, deterministic test patterns which can be fed to inputs of an integrated circuit (1; 21) to be tested, are produced, and having comparison means (12; 30) for comparing test output patterns of the integrated circuit (1; 21) to at least one desired output pattern, the arrangement being provided outside the integrated circuit (1; 21) to be tested, and a masking logic circuit (13; 29) being provided which makes sure that the comparison means (12; 30) compare exclusively predetermined test output patterns of the integrated circuit (1; 21) to be tested to the desired output patterns.

2. An arrangement as claimed in claim 1, **characterized in that**, provided as means (3, 4, 5, 6; 22, 23, 24, 25, 26, 27) for test pattern generation is a bit flipping controller (6; 27) which controls bit flipping logic circuits (3, 4, 5; 23, 24, 25, 26,) such that the deterministic data words are modified in a bitwise fashion such that the predetermined, deterministic test patterns are produced.

3. An arrangement as claimed in claim 1, **characterized in that** the desired output pattern is generated by means of the data word generator (2) and the means (3, 4, 5, 6) for test pattern generation.

## Revendications

1. Dispositif de test d'un circuit intégré (1 ; 21) avec un générateur de mots de données (2 ; 22) qui délivre des mots de données déterministes avec des moyens (3, 4, 5, 6 ; 22, 23, 24, 25, 26, 27) pour la génération de modèles de test qui changent les mots de données déterministes de manière à former des modèles de test préalablement déterminés qui peuvent être amenés aux entrées d'un circuit intégré à tester (1 ; 21) et avec des moyens de comparaison (12 ; 30) pour comparer les modèles de sortie de test du circuit intégré (1 ; 21) avec des modèles de sortie de consigne, dans lequel le dispositif est prévu en dehors du circuit intégré (1 ; 21) à tester, une logique de masquage (13, 29) étant prévue et permettant que les moyens de comparaison (12 ; 30) comparent exclusivement des modèles de sortie de test préalablement déterminés du circuit intégré à tester (1 ; 21) avec les modèles de sortie de consigne.

2. Dispositif selon la revendication 1,
**caractérisé en ce**
**qu'**une commande de bit-flipping (6 ; 27) est prévue comme moyens (3, 4, 5, 6 ; 22, 23, 24, 25, 26, 27) de génération de modèles de test et commande les logiques de bit-flipping (3, 4, 5 ; 23, 24, 25, 26) de telle sorte que les mots de données déterministes soient modifiés par bits de telle sorte qu'il se forme des modèles de test déterministes préalablement déterminés.

3. Dispositif selon la revendication 1,
**caractérisé en ce**
**que** les modèles de sortie de consigne sont produits à l'aide du générateur de mots de données (2) et avec des moyens (3, 4, 5, 6) pour la génération de modèles de test.
